(19) Europäisches Patentamt

European Patent Office

Office européen des brevets

(11) **EP 0 936 621 B1**

(12) **EUROPEAN PATENT SPECIFICATION**

(45) Date of publication and mention
of the grant of the patent:
**26.04.2006 Bulletin 2006/17**

(51) Int Cl.:
*G11C 7/06* (2006.01)   *G11C 16/06* (2006.01)

(21) Application number: **98830067.9**

(22) Date of filing: **13.02.1998**

(54) **Improved sense amplifier for a non volatile memory with extended supply voltage range**

Verbesserter Leseverstärker für nichtflüchtigen Speicher mit erweitertem Versorgungsspannungsbereich

Amplficateur de détection améliorée pour mémoire non volatile avec plage de tensions d'alimentation étendue

(84) Designated Contracting States:
**DE FR GB IT**

(43) Date of publication of application:
**18.08.1999 Bulletin 1999/33**

(73) Proprietor: **STMicroelectronics S.r.l.**
**20041 Agrate Brianza (Milano) (IT)**

(72) Inventors:
 • **Conte, Antonino**
  **95030 Tremestieri Etneo (CT) (IT)**

 • **Demange, Nicolas**
  **57160 Lessy (FR)**

(74) Representative: **Dini, Roberto et al**
**c/o Metroconsult S.r.l.**
**Piazza Cavour 3**
**10060 None (Torino) (IT)**

(56) References cited:
**EP-A- 0 320 779      EP-A- 0 352 524**
**EP-A- 0 477 369      EP-A- 0 642 132**

## Description

This invention concerns a memory sense amplifier circuit, specifically EEPROM memories, operating in an extended supply voltage range (1,8 - 7,0 V).

Reference herein will be made to conventional terms applying to the MOS (Metal Oxide Semiconductor) transistor technology. Specifically, the term "gate" will mean the control electrode or input electrode or control gate of a MOS transistor, the term "drain" the load electrode or output electrode and "source" the source electrode or output electrode.

EEPROM memories have data stored in a transistor with a floating gate. According to the logic state available, a positive or negative electric charge is captured in the gate to store either 0 or 1, modifying the transistor threshold. If there are no charges trapped in the gate, the memory cell is called "virgin", otherwise it is called "written" or "erased". The logic state, charge sign and status - either erased or written - depend from the standards that are likely to change from one product to another.

The logic state is detected by the cell based on the current that flows through it under known conditions. If a negative charge is trapped in the floating gate, then the cell threshold is higher than the one related to a virgin cell. On the contrary, if the trapped charge is a positive one, then the threshold is lower. Information is generally recovered from a cell comparing its own current with that of a virgin cell subject to the same conditions through an amplifier, called "sense amplifier". Conventional sense amplifier circuits have this operation carried out by a current/voltage conversion in two different branches where both currents are flown to.

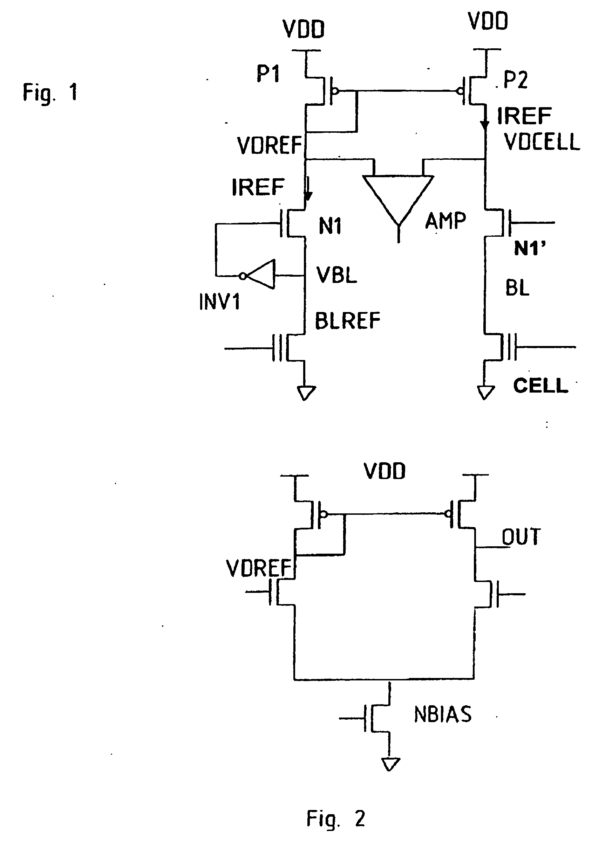

Sense amplifiers already known are often based on a current mirror between two branches (Fig. 1). Memory cells drains CELL organized to a matrix are connected with a 'bit line" BL and a decoder not shown in Fig. 1 selects one of the cells. One circuit is connected with the bit line BL of the selected cell; another identical circuit is connected with a virgin cell located outside the matrix. Also the drain of a reference cell REF is connected in a fully symmetrical mode with its bit line BLREF.

Then two currents are converted into voltages through a current/voltage converter, which consists of two transistors P1 and P2, usually p-channel MOS in a current mirror configuration, as represented in Fig. 1. These voltages (called VDREF and VDCELL) are sent to the inputs of a differential comparator AMP, which compares them and delivers a logic value representative of the read cell status. Normally, the differential comparator AMP consists of a classic source coupling differential stage NMOS with an active load represented by a transistor PMOS, as it can be seen in Fig. 2. This solution has some limitations for low power applications as it will be explained later.

Considering the reference side, i.e. the one connected with the reference cell REF, we see a circuit connected with the reference cell drain REF; this circuit consists substantially of a n-channel MOS transistor N1, whose control electrode or gate is driven by an inverter INV1 controlled by the voltage on the bit line BLREF. A biasing voltage of the bit line VBL is applied by this circuit on the bit line BLREF, i.e. on the reference cell drain REF. This bit line VBL biasing voltage shall be high enough to supply a high enough voltage between drain and source voltage VDS on the cell to be read.

The biasing voltage of the bit line VBL is a function of the threshold voltage or inversion of the inverter INV1 and of the threshold voltage (called VTN1) of the transistor N1. A load represented in Fig. 1 by the p-channel transistor P1 belonging to the current mirror connects the transistor drain N1 with the supply voltage VDD.

Current IREF flowing through the reference cell REF and in the transistor N1 shall be reflected (mirrors) in the sense amplifier from the cell being read. For this purpose the transistor P1 is connected to form a diode and reflects (mirrors) the current IREF into the other identical transistor P2.

The differential comparator AMP detailed in Fig. 2 shall be able to operate linearly to ensure a correct comparison between the voltages VDREF and VDCELL, except that said condition will result in a lower limit eg. for the voltage VDREF, which equals the voltage drop determined in the differential amplifier by the threshold voltage of the active load transistor, plus the overvoltage on the active load, plus the drain source voltage drop on the biasing transistor.

At the same time, as it can be seen in Fig. 1, the voltage VDREF is a function of the supply voltage VDD less the voltage drop due to the threshold voltage of the transistor P1 and overdrive voltage due to the current mirror reflection IREF.

Therefore, if the supply voltage VDD falls below 2V, the differential comparator AMP will not be able to operate correctly in its amplifying range.

As a result, a different solution is required to ensure an efficient functionality of the read operation at low supply voltages.

It is the object of this invention to provide a circuitry solution differing from the ones already known as described above, to ensure application of a simpler comparator scheme with good switching performance over an extended voltage range (1,8 -7 V).

To reach such purposes, it is the object of this invention to provide a sense amplifier incorporating the characteristics of the annexed claims, which form integral part of tis description.

Further purposes, features and benefits of this invention will become apparent from the following detailed description and annexed drawings, which are only supplied by way of a non limiting example, wherein:

-   Fig. 1 shows schematically the circuit of a known sense amplifier;
-   Fig. 2 shows a classic source coupling differential stage NMOS;
- Fig. 3 shows the sense amplifier circuit according to this invention;
- Fig. 4 shows a preferred embodiment of the sense amplifier according to this invention.
- Fig. 5 shows the voltage trend as a function of time in the sense amplifier of Fig. 3;
- Fig. 6 shows the voltage trend as a function of time in the sense amplifier of Fig. 4.

The annexed Fig. 1 shows schematically a sense amplifier already known as described above. Similarly, a circuit as previously discussed is shown in Fig. 2.

It is the object of this invention to suggest the use of a comparator in a common source stage and an output stage configuration to improve switching time to high supply voltages (VDD > 5 V). This solution is based on the adoption of a bit line biasing which is independent with respect to VDD.

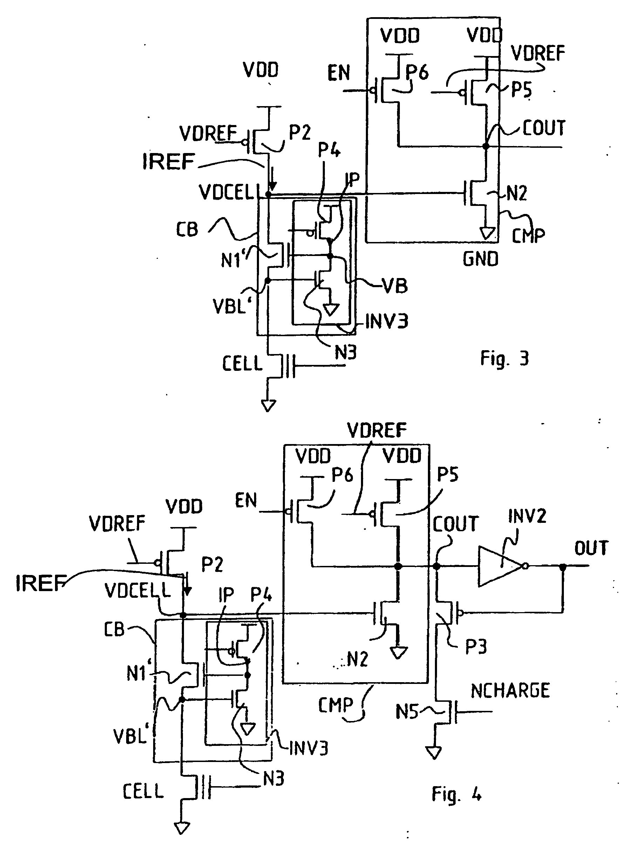

Therefore, a sense amplifier circuit according to this invention is represented in Fig. 3, where the biasing voltage VB of the transistor N1, is supplied through the inverter circuit INV3 of a biasing circuit CB, which is apt to make the biasing voltage VB of the transistor N1, and the biasing voltage VBL of the bit line independent with respect to the supply voltage VDD.

Like any MOS inverter the inverter circuit INV3 comprises an n-channel transistor N3 and a p-channel transistor P4. The transistor N3 of the circuit INV3 is connected like the inverter INV1 with the bit line BL in the known circuit shown in Fig. 1, whereas the transistor P4 is not connected with the bit line BL but operates according to the principle of a current mirror, i.e. said transistor P4 reflects a steady current IP generated separately through a current generator not represented here and injected on the gate of said transistor P4. This may happen, for instance, through a proper real current mirror circuit the transistor P4 may belong to, like a transistor that reflects the current IP forced into another transistor connected with it through the gate.

The value of said steady current IP is only chosen with the purpose of maintaining the transistor P4 in saturation. Thus, the voltage VB on the transistor gate N1, and consequently the biasing voltage VBL of the bit line determined by it, are independent from the supply voltage VDD, whereas they depend on the steady current IP that can be set according to the circuit requirements.

Then the biasing voltage VB of the transistor N1, is controlled using the steady current IP, generated separately. Thus, VBL will be independent from VDD, so that the supply voltage may even be below 2V, without jeopardizing the inverter circuit operation INV3. Moreover, independence of the bit line biasing voltage VBL from the supply voltage VDD also determines a consequent independence of the voltage VDCELL. For instance, if a supply voltage value VDD of 7V is given, it is anyway possible to design the inverter circuit INV3 in order to have a low voltage value, such as below 1 V, for VBL.

Therefore, the use of a simple amplifier in common source configuration with an active load is possible to ensure comparison also at very low supply voltages.

Fig. 3 shows in fact a comparator circuit CMP with a common source amplifier N2, obtained through a simple n-channel MOS transistor and a relevant p-channel MOS transistor P5 acting as an active load. The transistor P5 is maintained in saturation like the transistor P2; in fact, in this instance it is driven by the voltage VDREF also driving the transistor P2 itself.

Moreover, a p-channel MOS transistor P6 is provided, driven by an enable signal EN; when the enable signal EN is a low logic signal it will let the transistor drain which is coupled to the common source amplifier N2 to be brought to the supply voltage value VDD. Now, as it can be seen in Fig. 3, if the reference current IREF is mirrored into the branch where the transistor N1 controlled by the biasing voltage VB of the transistor N1, obtained by a steady current IP, according to the method described above it will force biasing of the bit line BL related to the selected cell. The following two events may ensue:

1. the current of the selected cell is higher than the reference current IREF, in which case the transistor N1 will automatically adjust its output voltage value VDCELL at a value very close to the predetermined voltage value VBL;

2. in the event of a cell with negative charges captured in the floating "gate", the current is very low with respect to IREF; therefore, the voltage VDCELL on the transistor drain N1 will be charged by the current IREF up to the supply voltage value VDD.

Under these premises the comparator CMP shown in Fig. 3 can be sized to obtain a threshold voltage higher than the biasing voltage VBL of the bit line for the transistor forming the amplifier N2; thus, the comparator output CMP will be set at the supply voltage value VDD in the event 1 and at the ground value GND in the event 2. This is possible because the supply voltage VDD is independent from the biasing voltage VBL of the bit line.

This solution offers the advantage of operating in an extended supply voltage range, in fact since the biasing voltage VBL of the bit line does not depend on the supply voltage VDD, it is always possible to choose the amplifier N2 dimensions to allow recognition of the logic states; moreover, the comparator CMP shown in Fig. 3 allows anyway a good switching time.

However, the drawback of such a simple circuit is that at the beginning of each read operation the output COUT of the comparator CMP has to be set to a known initial value. This occurs through the transistor P6 driven by the enable signal EN, which may be obtained for instance from the disable signal usually applied to charge the bit line BL before a read operation. Said initial value is preferably the value of the supply voltage VDD, otherwise the time required for switching could be too high, being limited by the biasing current of the transistor P1 used as an active load.

When the supply voltage VDD approaches 7V, the output of the comparator CMP is forced to 7V as its initial value, so that when switching takes place, the time required to switch from the supply voltage VDD to the ground voltage GND is higher than at the low supply voltages.

Therefore it is the object of this invention to provide an improved switching time for the comparator CMP shown in Fig. 4, using a p-channel MOS transistor P3, loop connected with the input and output of an inverter INV2 in series with the comparator CMP, which may also be used as a "buffer". The loop is enabled by a n-channel MOS transistor N5 driven by a signal indicated with NCHARGE. Such a signal is a high logic state signal for the time only required for switching, whereas it is usually a low logic state signal.

At the beginning of a read operation the signal NCHARGE takes a high logic state value, brings the transistor N5 in conduction, thus precharging the output COUT of the comparator CMP at about the threshold voltage value of the inverter INV2. If the input voltage of the comparator CMP is higher than its threshold voltage (in the read event of a cell with a negative charge trapped in the "gate"), the output will already be close to the inverter threshold INV2 and allow faster switching. At the end of the read operation NCHARGE is reset, thus limiting the inverter consumption to the "sensing" operation time alone.

During the read or "sensing" time, when the loop is enabled, the voltage on the comparator output OUT will be approximately equal to:

$$\text{VOUT} = \text{Vt} - \text{VSGP3},$$

where Vt is the threshold voltage of the inverter INV2, VSGP3 the voltage between the gate and the source of transistor P3.

Thus, the output voltage level VOUT is recognized as a low logic signal like in the absence of the loop with the signal NCHARGE at a low logic level.

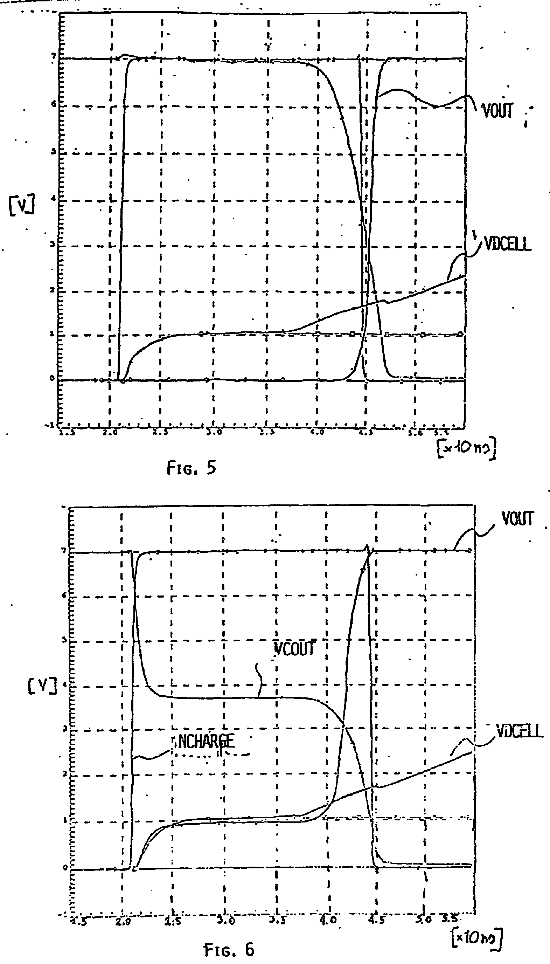

All this is better explained looking at Figs. 5 and 6 where the trend by simulation of several voltages related to the circuits of Fig. 4 (with the loop) and Fig. 3 (without loop) are shown respectively.

The trend of the output voltage VCOUT and voltage VDCELL is shown in Fig. 5.

Fig. 6 shows the trend related to the loop output voltage VOUT, comparator output voltage VCOUT, signal NCHARGE and voltage VDCELL.

As it can be seen from the two figures above, with the loop "sensing" time improvement of about 3nsecs at 5 V and about 4nsecs at 7 V (in fact, sensing time at 7 V ranges from about 24,2 to about 20.6 ns) is shown. Fig. 6 also illustrates the precharge effect of the node COUT, which, as soon as the signal NCHARGE reaches 7V supply voltage, will range from the 7V level to which it has been conducted by the transistor P6 to about 3.8 V corresponding to the threshold voltage of the inverter INV2, and then quickly towards the ground value GND as soon as the voltage VDCELL exceeds the threshold value of the amplifier N2.

As it results from the description and the figures, the adopted solution is based on a reliable control of the VBL value (biasing voltage of the bit line) with respect to the supply voltage VDD and provides a good switching time across an extended range of supply voltage values (1,87 V).

During the second comparator stage the loop improves switching time at the upper limit of the supply voltage range.

The loop is enabled only during the read or "sensing" time so as to limit energy consumption specifically at high supply voltages.

Enabling the loop does not affect the comparator output logic level.

Among a large number of possible uses of this invention, a preferred application may be associated with a smart card, like a credit card.

The benefits of a memory sense amplifier according to this invention are quite apparent from the above description and annexed drawings. It is also obvious that many changes are possible to the embodiment described above by way of example, without departing from the invention as defined by the appended claims.

**Claims**

1. A memory sense amplifier, specifically for EEPROM memories, operating in an extended voltage range, comprising:

   - a comparator that on a first input receives a signal available on a first bit line representative of the current flowing through a read memory cell (CELL) and on a second input receives a signal representative of a reference current available on a second bit line;
   - a first polarization circuit coupled to said first bit line, which fixes a first polarization voltage (VBL') on the first bit line; and
   - a second polarisation circuit coupled to said second bit line, which fixes a second polarization voltage (VBL) on said second bit line, comprising a first transistor (N1) whose control gate is controlled by a first inverter (INV1) controlled by the second polarization voltage (VBL),

   **characterized in that**:

   - the first polarisation circuit comprises:

- a second transistor (N 1') coupled in series with said read memory cell,
- a third transistor (N3) and a fourth transistor (P4) coupled in series with each other between a reference potential and a supply voltage (VDD),
- wherein the gate of the third transistor (N3) is controlled by the first polarisation voltage (VBL') and the gate of the fourth transistor (P4) is connected to a steady reference voltage in order to provide the first polarization voltage (VBL'), which is independent in use from the variation of the value of the supply voltage (VDD);

- the comparator comprises:

- a fifth transistor (P5) and a sixth transistor (N2) coupled in series with each other between a reference potential and a power supply;
- the sixth transistor (N2) being in a common source configuration and the fifth transistor (P5) being an active load for the sixth transistor (N2);
- said fifth transistor (P5) being driven by a reference potential in the gate that maintains it in saturation;
- said sixth transistor (N2) being driven by a voltage determined by the difference between the current flowing through said read memory cell and said reference current available on said second bit line.

2. A memory sense amplifier according to claim 1, **characterized in that** an output stage is coupled to said sense amplifier, the output stage comprising:

- a second inverter (INV2) coupled with the input of to the interconnection of the fifth transistor (P5) and the sixth transistor (N2);
- a seventh transistor (P3) and an eighth transistor (N5) coupled in series with each other between the input of said second inverter (INV2) and a reference potential, wherein the seventh transistor (P3) is controlled by the output of said second inverter (INV2) and the gate of the eighth transistor (N5) is controlled by a read operation signal (NCHARGE).

3. A memory sense amplifier according to claim 1 or 2, **characterized in that** said second transistor (N1') drives said sixth transistor (N2) in a common source configuration and that said second transistor (N1') will adjust its output voltage value (VDCELL) to the value of said polarization voltage (VBL') if the current of said read memory cell (CELL) is higher than a reference current (IREF), whereas, on the contrary, said output voltage value (VDCELL) will be substantially brought to the supply voltage value (VDD).

4. A memory sense amplifier according to one or more of the previous claims, **characterized in that** said sixth transistor (N2) being in a common source configuration is so sized that the threshold voltage (VTN2) of said sixth transistor (N2) is higher than said polarization voltage (VBL').

5. A memory sense amplifier according to claims 3 and 4, **characterized in that** the comparator output (CMP) is established at the supply voltage value (VDD) if the current of the said read memory cell (CELL) is higher than said reference current (IREF) or on the contrary at the ground value (GND).

6. A memory sense amplifier according to claim 2, **characterized in that** the gate of said eighth transistor (N5) is driven by a high logic state operation signal (NCHARGE) only for the time required for a read operation, whereas it is normally at low logic state.

7. A memory sense amplifier according to one or more of the previous claims, **characterized in that** said first polarisation circuit that releases a polarization value (VBL') which is independent in use from the variation of the value of the supply voltage (VDD), is based on the use of a steady current (IP) generated by means of a second circuit generating said reference voltage on the gate of said fourth transistor (P4).

**Patentansprüche**

1. Speicher-Leseverstärker, insbesondere für EEPROM-Speicher, der über einen ausgedehnten Spannungsbereich arbeitet, mit

- einem Komparator, der an einem ersten Eingang ein an einer ersten Bit-Leitung auftretendes Signal erhält, das den durch eine Lesespeicherzelle (CELL) fließenden Strom repräsentiert, und der an einem zweiten Eingang ein Signal erhält, das einen Referenzstrom auf der zweiten Bit-Leitung repräsentiert;
- einer mit der ersten Bit-Leitung gekoppelten ersten Polarisationsschaltung, die eine erste Polarisationsspannung (VBL') auf der ersten Bitleitung festlegt; und
- einer mit der zweiten Bit-Leitung gekoppelten zweiten Polarisationsschaltung, die eine zweite Polarisationsspannung (VBL) auf der zweiten Bitleitung festlegt und die einen ersten Transistor (N1) enthält, dessen Steuer-Gate durch einen ersten Inverter (INV1) gesteuert wird, der wiederum durch die zweite Polarisationsspannung (VBL) gesteuert wird;

**dadurch gekennzeichnet,**

- **dass** die erste Polarisationsschaltung

- einen zweiten Transistor (N1') enthält, der in Serie mit der Lesespeicherzelle geschaltet ist, und
- einen dritten Transistor (N3) und einen vierten Transistor (P4) enthält, die miteinander in Serie liegen und zwischen ein Referenzpotential und einer Betriebsspannung (VDD) geschaltet sind,
- wobei das Gate des dritten Transistors (N3) durch die erste Polarisationsspannung (VBL') gesteuert und das Gate des vierten Transistors (P4) mit einer konstanten Referenzspannung verbunden ist, um die erste Polarisationsspannung (VBL') zu erzeugen, die unabhängig von Schwankungen der Betriebsspannung (VDD) ist;

- **dass** der Komparator

- einen fünften Transistor (P5) und einen sechsten Transistor (N2) enthält, die miteinander in Serie liegen und zwischen ein Referenzpotential und einer Betriebsspannung geschaltet sind,
- wobei der sechste Transistor (N2) in Common-Source-Schaltung geschaltet ist und der fünfte Transistor (P5) als aktive Last für den sechsten Transistor (N2) dient;
- wobei der fünfte Transistor (P5) am Gate durch ein Referenzpotential angesteuert wird, das ihn in der Sättigung hält; und
- wobei der sechste Transistor (N2) durch eine Spannung angesteuert wird, die durch die Differenz zwischen dem durch die Speicherzelle fließenden Strom und dem Referenzstrom auf der zweiten Bit-Leitung bestimmt wird.

2. Speicher-Leseverstärker nach Anspruch 1, **dadurch gekennzeichnet, dass** mit dem Leseverstärker eine Ausgangsstufe gekoppelt ist, die

- einen zweiten Inverter (INV2) enthält, dessen Eingang mit einem Verbindungspunkt zwischen dem fünften Transistor (P5) und dem sechsten Transistor (N2) verbunden ist; und
- einen siebten Transistor (P3) und einen achten Transistor (N5) enthält, die in Serie miteinander und zwischen den Eingang des zweiten Inverters (INV2) und ein Referenzpotential geschaltet sind, wobei der siebte Transistor (P3) durch den Ausgang des zweiten Inverters (INV2) und das Gate des achten Transistors (N5) durch ein Lese-Aktivierungssignal (NCHARGE) gesteuert werden.

3. Speicher-Leseverstärker nach Anspruch 1 oder 2, **dadurch gekennzeichnet, dass** der zweite Transistor (N1') den sechsten Transistor (N2) in Common-Source-Schaltung ansteuert und dass der zweite Transistor (N1') seinen Ausgangsspannungswert (VDCELL) an den Wert der Polarisationsspannung (VBL') anpasst, wenn der Strom in der Lesespeicherzelle (CELL) höher als der Referenzstrom (IREF) ist, während im gegenteiligen Fall der Ausgangsspannungswert (VDCELL) im wesentlichen auf den Wert der Betriebsspannung (VDD) gebracht wird.

4. Speicher-Leseverstärker nach einem oder mehreren der vorgehenden Ansprüche, **dadurch gekennzeichnet, dass** der in Common-Source-Schaltung geschaltete Transistor (N2) in der Größe so dimensioniert ist, dass sein Schwellenspannung höher ist als die Polarisationsspannung (VBL').

5. Speicher-Leseverstärker nach Anspruch 3 oder 4, **dadurch gekennzeichnet, dass** das Ausgangssignal (CMP) des Komparators auf dem Wert der Betriebsspannung (VDD) liegt, wenn der Strom in der Lesespeicherzelle (CELL) höher als der Referenzstrom (IREF) ist, während es im gegenteiligen Fall auf Massepotential (GND) liegt.

6. Speicher-Leseverstärker nach Anspruch 2, **dadurch gekennzeichnet, dass** das Gate des achten Transistors (N5) durch ein Hoch-Zustands-Aktivierungssignal (NCHARGE) nur für die Zeit des Lesevorganges angesteuert wird, während es normalerweise sich im Niedrig-Zustand befindet.

7. Speicher-Leseverstärker nach einem oder mehreren der vorgehenden Ansprüche, **dadurch gekennzeichnet, dass** die erste Polarisationsschaltung, die einen Polarisationswert (VBL') abgibt, der unabhängig von dem Wert der Betriebsspannung (VDD) ist, sich auf einen Konstantstrom (IP) stützt, der mittels einer zweiten Schaltung erzeugt wird, die die Referenzspannung am Gate des vierten Transistors (P4) erzeugt.

**Revendications**

1. Amplificateur de lecture de mémoire, spécifiquement pour des mémoires EEPROM (mémoire morte effaçable et programmable électriquement), fonctionnant dans une plage de tension étendue, comportant :

- un comparateur qui, sur une première entrée, reçoit un signal disponible sur une première ligne de bits représentatif du courant circulant à travers une cellule de mémoire de lecture (CELL) et, sur une seconde entrée, reçoit un signal représentatif d'un courant de référence disponible sur une seconde ligne de bits,
- un premier circuit de polarisation couplé à ladite première ligne de bits, qui fixe une première tension de polarisation (VBL') sur la première ligne de bits, et
- un second circuit de polarisation couplé à ladite seconde ligne de bits, qui fixe une seconde tension de polarisation (VBL) sur ladite seconde ligne de bits, comportant un premier transistor (N1) dont la grille de commande est commandée par un premier inverseur (INV1) commandé par la seconde tension de polarisation (VBL),

**caractérisé en ce que** :

- le premier circuit de polarisation comporte :

  - un deuxième transistor (N1') couplé en série avec ladite cellule de mémoire de lecture,
  - un troisième transistor (N3) et un quatrième transistor (P4) couplés en série l'un avec l'autre entre un potentiel de référence et une tension d'alimentation (VDD),
  - dans lequel la grille du troisième transistor (N3) est commandée par la première tension de polarisation (VBL') et la grille du quatrième transistor (P4) est connectée à une tension de référence constante afin de délivrer la première tension de polarisation (VBL'), qui est indépendante en fonctionnement de la variation de la valeur de la tension d'alimentation (VDD),

- le comparateur comporte :

  - un cinquième transistor (P5) et un sixième transistor (N2) couplés en série l'un avec l'autre entre un potentiel de référence et une alimentation,
  - le sixième transistor (N2) étant dans une configuration de source commune et le cinquième transistor (P5) étant une charge active pour le sixième transistor (N2),
  - ledit cinquième transistor (P5) étant attaqué par un potentiel de référence dans la grille qui le maintient en saturation,
  - ledit sixième transistor (N2) étant attaqué par une tension déterminée par la différence entre le courant circulant à travers ladite cellule de mémoire de lecture et ledit courant de référence disponible sur ladite seconde ligne de bits.

2. Amplificateur de lecture de mémoire selon la revendication 1, **caractérisé en ce qu'**un étage de sortie est couplé audit amplificateur de lecture, l'étage de sortie comportant :

   - un second inverseur (INV2) couplé à l'entrée de l'interconnexion du cinquième transistor (P5) et du sixième transistor (N2),
   - un septième transistor (P3) et un huitième transistor (N5) couplés en série l'un avec l'autre entre l'entrée dudit second inverseur (INV2) et un potentiel de référence, le septième transistor (P3) étant commandé par la sortie du second inverseur (INV2) et la grille du huitième transistor (N5) étant commandée par un signal d'opération de lecture (NCHARGE).

3. Amplificateur de lecture de mémoire selon la revendication 1 ou 2, **caractérisé en ce que** ledit deuxième transistor (N1') attaque ledit sixième transistor (N2) dans une configuration de source commune et **en ce que** ledit deuxième transistor (N1') va ajuster sa valeur de tension de sortie (VDCELL) sur la valeur de ladite tension de polarisation (VBL') si le courant de ladite cellule de mémoire de lecture (CELL) est supérieur à un courant de référence (IREF), alors que, au contraire, ladite valeur de tension de sortie (VDCELL) va être sensiblement amenée à la valeur de tension d'alimentation (VDD).

4. Amplificateur de lecture de mémoire selon une ou plusieurs des revendications précédentes, **caractérisé en ce que** ledit sixième transistor (N2) étant dans une configuration de source commune est dimensionné de sorte que la tension de seuil (VTN2) dudit sixième transistor (N2) est supérieure à ladite tension de polarisation (VBL').

5. Amplificateur de lecture de mémoire selon les revendications 3 et 4, **caractérisé en ce que** la sortie de comparateur (CMP) est établie à la valeur de tension d'alimentation (VDD) si le courant de ladite cellule de mémoire de lecture (CELL) est supérieur audit courant de référence (IREF) ou au contraire à la valeur de la masse (GND).

6. Amplificateur de lecture de mémoire selon la revendication 2, **caractérisé en ce que** la grille dudit huitième transistor (N5) est attaquée par un signal d'opération d'état logique haut (NCHARGE) uniquement pendant la durée requise pour une opération de lecture, alors qu'il est normalement à un état logique bas.

7. Amplificateur de lecture de mémoire selon une ou plusieurs des revendications précédentes, **caracté-**

**risé en ce que** ledit premier circuit de polarisation qui libère une valeur de polarisation (VBL') qui est indépendante en utilisation de la variation de la valeur de la tension d'alimentation (VDD), est basé sur l'utilisation d'un courant stable (IP) généré par l'intermédiaire d'un second circuit générant ladite tension de référence sur la grille dudit quatrième transistor (P4).

Fig. 1

Fig. 2

Fig. 3

Fig. 4

FIG. 5

FIG. 6